# EUROPEAN PATENT SPECIFICATION

(11) **EP 4 322 213 B1**
(45) Date of publication and mention of the grant of the patent: **26.02.2025**
(21) Application number: 22204073.5
(22) Date of filing: 27.10.2022
(51) Int. Cl.: G06K 1/12, G06K 19/04, G06K 19/06, H01L 23/544, H01L 23/552

(54) **CHIP PACKAGE STRUCTURE AND PACKAGE MODULE THEREOF**
CHIPGEHÄUSESTRUKTUR UND GEHÄUSEMODUL DAFÜR
STRUCTURE DE BOÎTIER DE PUCE ET MODULE DE BOÎTIER ASSOCIÉ

(30) Priority: 08.08.2022 TW 111129660
(43) Date of publication of application: 14.02.2024
(73) Proprietor: Azurewave Technologies, Inc., 231 New Taipei City (TW)
(72) Inventor: LIAO, Chih-Hao, Taipei (TW); HUANG, Hsin-Yeh, Taipei (TW); WU, Shu-Han, Taipei (TW)
(74) Representative: Viering, Jentschura & Partner mbB Patent- und Rechtsanwälte

(56) References cited:
- EP-A2- 3 346 492
- US-A1- 2020 105 665
- US-A1- 2022 199 423
- US-B2- 11 362 009

## Description

### FIELD OF THE DISCLOSURE

The present disclosure relates to a package structure, and more particularly to a chip package structure.

### BACKGROUND OF THE DISCLOSURE

US2020/105665A1 discloses a semiconductor package includes a semiconductor chip having an active surface on which a connection pad is disposed and an inactive surface opposing the active surface; a first encapsulant covering at least a portion of each of the inactive surface and side surfaces of the semiconductor chip, and having one or more recessed portions recessed towards the inactive surface of the semiconductor chip; a metal layer disposed on the first encapsulant, and filling at least a portion of each of the recessed portions; and an interconnect structure disposed on the active surface of the semiconductor chip, and including a redistribution layer electrically connected to the connection pad. A surface of the metal layer in contact with the first encapsulant has a surface roughness greater than a surface roughness of a surface of the metal layer spaced apart from the first encapsulant.

EP3346492A2 discloses a semiconductor chip package includes a substrate; a semiconductor die mounted on the substrate, wherein the semiconductor die comprises a bond pad disposed on an active surface of the semiconductor die, and a passivation layer covering perimeter of the bond pad, wherein a bond pad opening in the passivation layer exposes a central area of the bond pad; a conductive paste post printed on the exposed central area of the bond pad; and a bonding wire secured to a top surface of the conductive paste post. The conductive paste post preferably comprises copper paste.

US2022/199423A1 discloses a semiconductor device has a semiconductor package including a substrate with a land grid array. A component is disposed over the substrate. An encapsulant is deposited over the component. The land grid array remains outside the encapsulant. A metal mask having a fiducial marker is disposed over the land grid array. A shielding layer is formed over the semiconductor package. The metal mask is removed after forming the shielding layer.

A conventional chip package structure has a recognition code printed on a top side of an encapsulant thereof. However, the recognition code is not coplanar with the top side of the encapsulant, such that the recognition code can easily suffer damage that may cause it to become unrecognizable.

### SUMMARY OF THE DISCLOSURE

In response to the above-referenced technical inadequacy, the present disclosure provides a chip package structure as defined in claim 1. Said chip package structure effectively improves the issues associated with conventional chip package structures.

In one aspect, the present disclosure provides a chip package structure, which includes a substrate, a chip module, an encapsulant, and a recognition contrast layer. The substrate has a first board surface and a second board surface that is opposite to the first board surface. The substrate has a plurality of conductive portions arranged on the second board surface. The chip module is mounted on the first board surface and is electrically coupled to the conductive portions. The encapsulant is formed on the first board surface. The chip module is embedded in the encapsulant. The encapsulant has a patterned trench that is recessed in a top surface thereof and that corresponds in shape to a predetermined two-dimensional (2D) code pattern. The recognition contrast layer is filled in the patterned trench. The recognition contrast layer and the top surface of the encapsulant respectively have different colors that conform to grade A or grade B in the ISO/IEC 15415 standard. The recognition contrast layer is coplanar with the top surface of the encapsulant so as to jointly form the predetermined 2D code pattern having a planar shape. The patterned trench has a plurality of slots that are separate from each other, and each of the slots has a depth within a range from 15 µm to 30 µm. The chip module includes at least one chip and a plurality of passive components, and wherein the at least one chip and the passive components are mounted on the first board surface, and a top side of the at least one chip is exposed from at least one of the slots and is covered by the recognition contrast layer.

Therefore, the chip package structure of the present disclosure is provided with the predetermined 2D code pattern that is formed by a structural cooperation of the encapsulant and the recognition contrast layer, so that the predetermined 2D code pattern not only provides for high recognition accuracy, but also has a planar shape that is not easily damaged.

Specifically, in the chip package structure provided by the present disclosure, the recognition contrast layer covers inner walls of the slots, thereby effectively preventing the at least one chip from being affected by the external environment.

These and other aspects of the present disclosure will become apparent from the following description of the embodiment taken in conjunction with the following drawings and their captions, although variations and modifications therein may be affected without departing from the scope of the appended claims.

### BRIEF DESCRIPTION OF THE DRAWINGS

The described embodiments may be better understood by reference to the following description and the accompanying drawings, in which:
FIG. 1 is a perspective view of a chip package structure according to a first embodiment of the present disclosure;
FIG. 2 is a cross-sectional view taken along line II-II of FIG. 1;
FIG. 3 is an enlarged view of part III of FIG. 2;
FIG. 4 is a perspective view showing an encapsulant of FIG. 1;
FIG. 5 is a cross-sectional view of the chip package structure according to a second embodiment of the present disclosure;
FIG. 6 is an enlarged view of part VI of FIG. 5;
FIG. 7 is a cross-sectional view of the chip package structure according to a third embodiment of the present disclosure;
FIG. 8 is an enlarged view of part VIII of FIG. 7; and
FIG. 9 is a perspective view of the chip package structure according to a fourth embodiment of the present disclosure.

### DETAILED DESCRIPTION OF THE EXEMPLARY EMBODIMENTS

The present disclosure is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a", "an", and "the" includes plural reference, and the meaning of "in" includes "in" and "on". Titles or subtitles can be used herein for the convenience of a reader, which shall have no influence on the scope of the present disclosure.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present disclosure or of any exemplified term. Likewise, the present disclosure is not limited to various embodiments given herein. Numbering terms such as "first", "second" or "third" can be used to describe various components, signals or the like, which are for distinguishing one component/signal from another one only, and are not intended to, nor should be construed to impose any substantive limitations on the components, signals or the like.

### [First Embodiment]

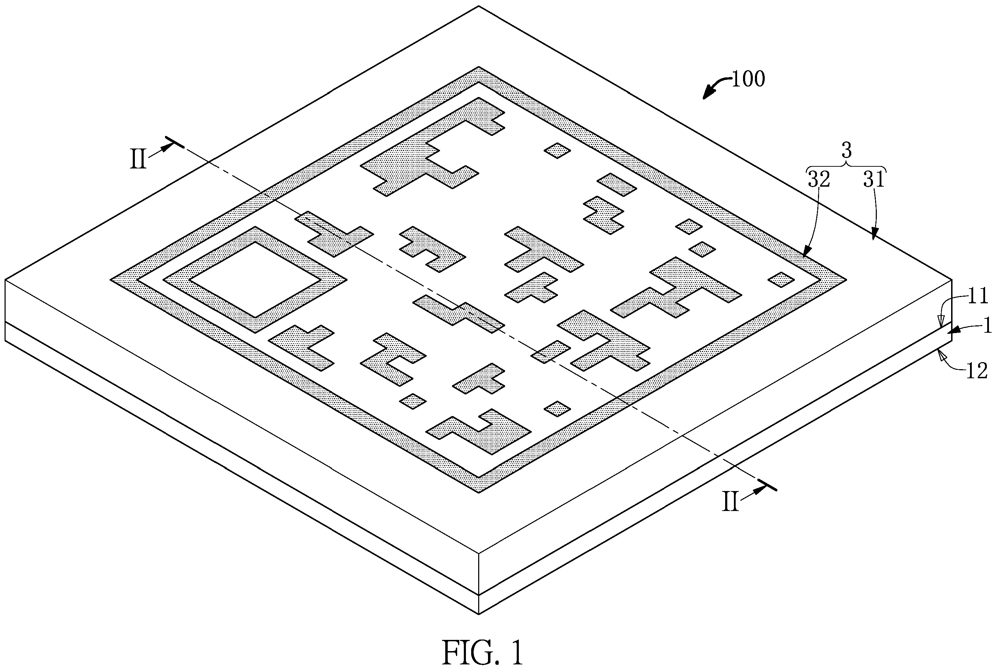

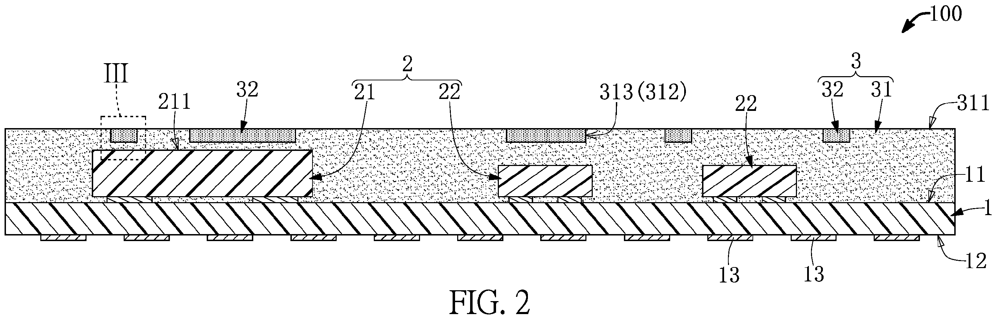

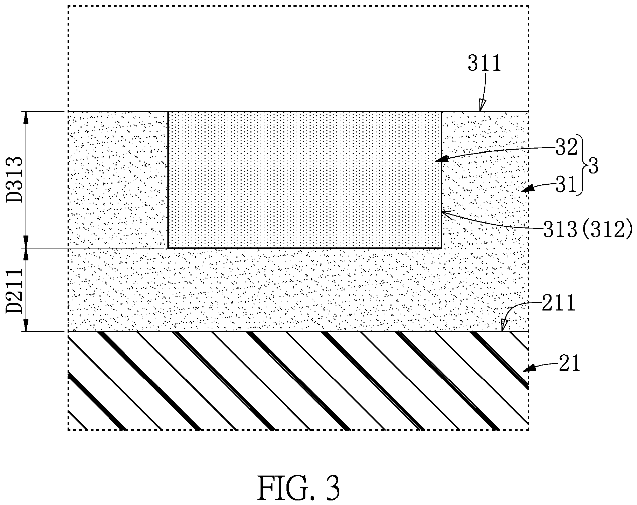

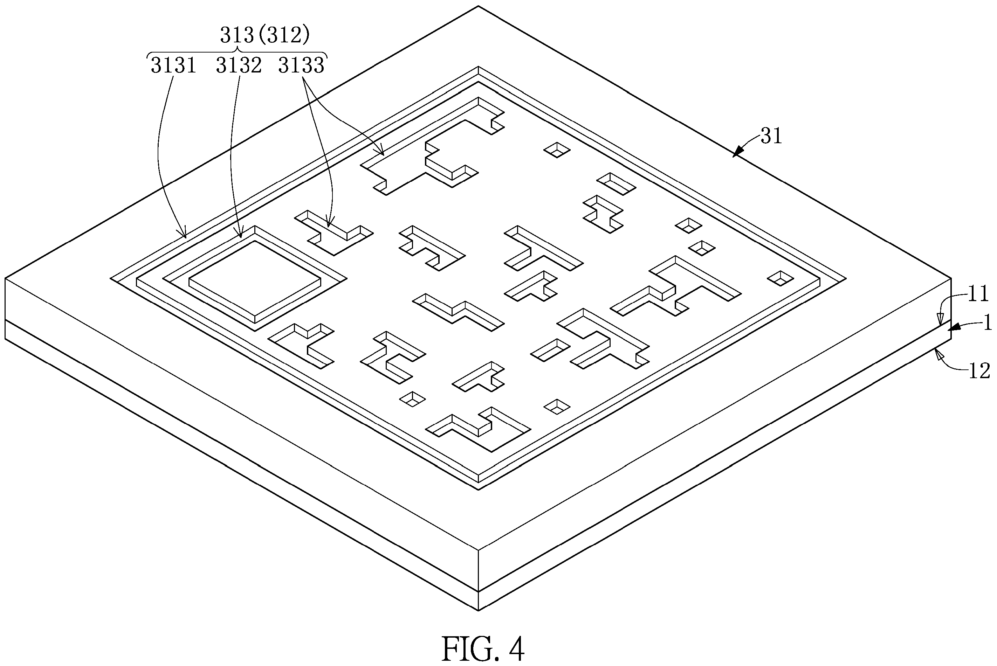

Referring to FIG. 1 to FIG. 4, a first embodiment of the present disclosure provides a chip package structure 100 preferably being a system in package (SiP). The chip package structure 100 includes a substrate 1 having a flat shape, a chip module 2 mounted on the substrate 1, and a package module 3 that is formed on the substrate 1.

It should be noted that the package module 3 in the present embodiment is described in cooperation with the substrate 1 and the chip module 2. For example, in other embodiments of the present disclosure not shown in the drawings, the package module 3 can be used in cooperation with other components.

In the present embodiment, the substrate 1 has a first board surface 11 and a second board surface 12 that is opposite to the first board surface 11, and the substrate 1 has a plurality of conductive portions 13 arranged on the second board surface 12. The conductive portions 13 are metal pads that can be used in a surface mount technology (SMT) manner, but in other embodiments of the present disclosure not shown in the drawings, the conductive portions 13 can be other structures (e.g., insertion pins).

The chip module 2 is electrically coupled to the conductive portions 13 of the substrate 1. The chip module 2 includes at least one chip 21 and a plurality of passive components 22, and the at least one chip 21 and the passive components 22 are mounted on the first board surface 11. The connection manner between the at least one chip 21 (or the passive components 22) and the substrate 1 can be a flip chip manner or a wire bonding manner, but the present disclosure is not limited thereto.

Moreover, the type of the at least one chip 21 can be adjusted or changed according to design requirements. For example, the chip 21 can be a radio frequency identification (RFID) chip, a mobile payment chip, a machine-to-machine (M2M) chip, a wireless sensor chip, or a communication chip that is formed in other types.

The package module 3 includes an encapsulant 31 and a recognition contrast layer 32 that is formed on a part of the encapsulant 31. It should be noted that any package module provided without directly forming a recognition contrast layer on an encapsulant is different from the package module 3 of the present embodiment.

In the present embodiment, the encapsulant 31 is a molding compound for being accurately formed in a predetermined shape, but the present disclosure is not limited thereto. The encapsulant 31 is formed on the first board surface 11 of the substrate 1, and the chip module 2 is embedded in the encapsulant 31. In addition, in other embodiments of the present disclosure not shown in the drawings, the encapsulant 31 can further extend to cover a surrounding lateral side of the substrate 1 and the second board surface 12, but the conductive portions 13 need to be exposed from the encapsulant 31.

Furthermore, the encapsulant 31 has a patterned trench 312 that is recessed in a top surface 311 thereof and that corresponds in shape to a predetermined two-dimensional (2D) code pattern. The predetermined 2D code pattern in the present embodiment is a QR code, but the predetermined 2D code pattern can be adjusted or changed according to design requirements. For example, the predetermined 2D code pattern can be a data matrix, an aztec code, a PDF417, a micro PDF, a GS1 databar, or a pharmacode.

Specifically, the patterned trench 312 in the present embodiment has a plurality of slots 313 that are separate from each other, and each of the slots 313 is preferably a laser engraving slot and has a depth D313 within a range from 15 µm to 30 µm. The depths D313 of the slots 313 in the present embodiment are the same, but the present disclosure is not limited thereto. For example, in other embodiments of the present disclosure not shown in the drawings, the slots 313 can have depths D313 that are slightly different from one another according to design requirements.

In the present embodiment, the slots 313 include an outer square slot 3131, at least one inner square slot 3132, and a plurality of irregular slots 3133. An area surrounded by the outer square slot 3131 substantially occupies at least 70% of an area of the top surface 311 of the encapsulant 31, and four corners of the outer square slot 3131 are respectively spaced apart from four corners of the top surface 311 by a same interval. The at least one inner square slot 3132 and the irregular slots 3133 are arranged at an inner side of the outer square slot 3131, and the at least one inner square slot 3132 corresponds in position to at least one of the four corners of the outer square slot 3131.

In addition, a top side 211 of the at least one chip 21 is embedded in the encapsulant 31 and is spaced apart from at least one of the slots 313 adjacent thereto by a distance D211 within a range from 1 µm to 10 µm, but the present disclosure is not limited thereto. In other words, the depth (or the distance D211) of the top side 211 of the at least one chip 21 with respect to the encapsulant 31 is reduced due to an adjacent one of the slots 313, such that a probability of the at least chip 21 being affected by the external environment may be increased.

The recognition contrast layer 32 and the top surface 311 of the encapsulant 31 respectively have different colors that conform to grade A or grade B in the ISO/IEC 15415 standard. In the present embodiment, each of the recognition contrast layer 32 and the encapsulant 31 is of a single color (e.g., the recognition contrast layer 32 is a white toner layer, and the color of the encapsulant 31 is black), but the present disclosure is not limited thereto. For example, in other embodiments of the present disclosure not shown in the drawings, the recognition contrast layer 32 can be made of a material other than toner.

Specifically, the recognition contrast layer 32 is filled in the patterned trench 312 and is coplanar with the top surface 311 of the encapsulant 31, so that the recognition contrast layer 32 and the top surface 311 of the encapsulant 31 jointly form the predetermined 2D code pattern having a planar shape.

Accordingly, the chip package structure 100 of the present embodiment is provided with the predetermined 2D code pattern that is formed by a structural cooperation of the encapsulant 31 and the recognition contrast layer 32, so that the predetermined 2D code pattern not only has a high recognition, but also has a planar shape that is not easily damaged. Moreover, the recognition contrast layer 32 of the chip package structure 100 is provided to cover inner walls of the slots 313, thereby effectively preventing the at least one chip 21 from being affected by the external environment.

Furthermore, any 2D code not having a planar shape or not conforming to grade A or grade B in the ISO/IEC 15415 standard is different the predetermined 2D code pattern of the present embodiment that is formed in a planar shape through the recognition contrast layer 32 and the top surface 311 of the encapsulant 31.

### [Second Embodiment]

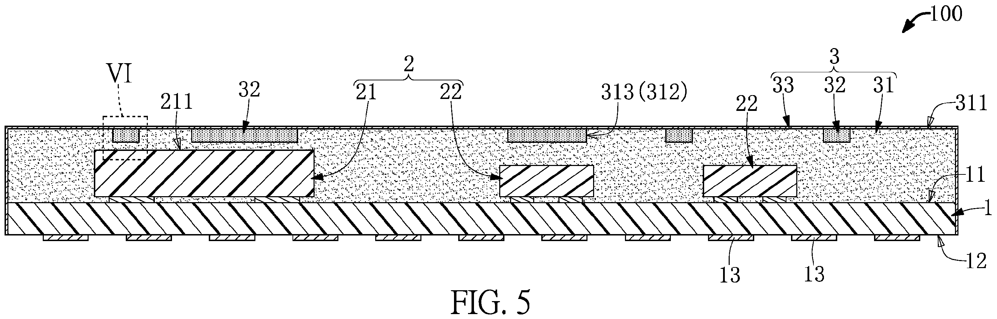

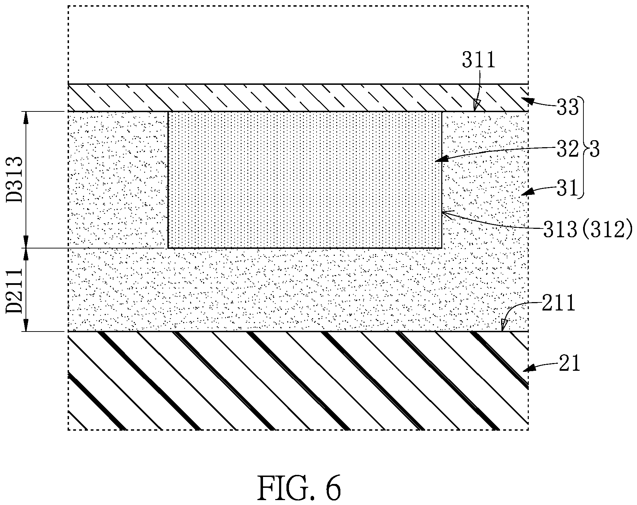

Referring to FIG. 5 and FIG. 6, a second embodiment of the present disclosure, which is similar to the first embodiment of the present disclosure, is provided. For the sake of brevity, descriptions of the same components in the first and second embodiments of the present disclosure will be omitted herein, and the following description only discloses different features between the first and second embodiments.

In the present embodiment, the chip package structure 100 further includes a transparent protective layer 33 arranged on an outer side thereof (e.g., the transparent protective layer 33 covers the predetermined 2D code pattern having the planar shape), thereby providing a dust-proof effect, a moisture-proof effect, and an anti-corrosion effect to the chip package structure 100 (or the predetermined 2D code pattern) through the transparent protective layer 33.

### [Third Embodiment]

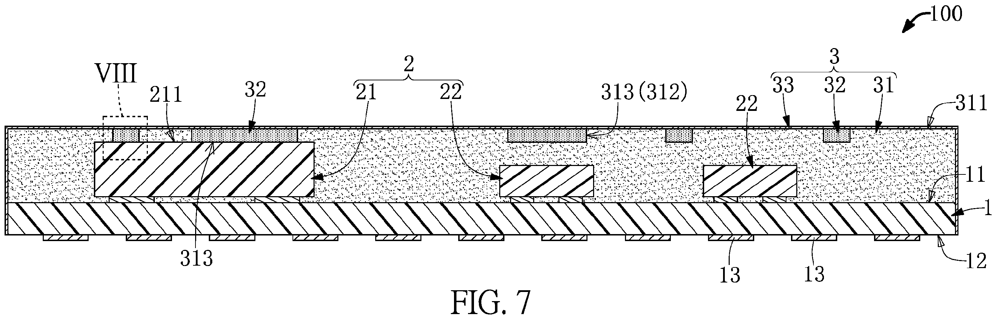

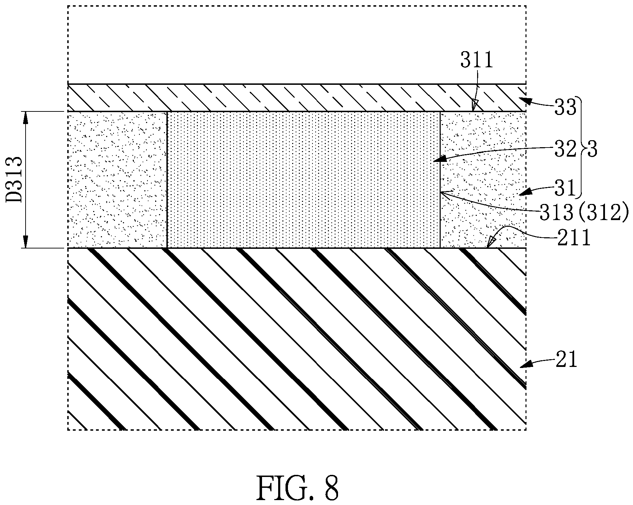

Referring to FIG. 7 and FIG. 8, a third embodiment of the present disclosure, which is similar to the first and second embodiments of the present disclosure, is provided. For the sake of brevity, descriptions of the same components in the first to third embodiments of the present disclosure will be omitted herein, and the following description only discloses different features among the first to third embodiments.

In the present embodiment, a top side 211 of the at least one chip 21 is exposed from at least one of the slots 313 and is covered by the recognition contrast layer 32. In other words, the top side 211 of the at least one chip 21 forms a bottom of the at least one of the slots 313 adjacent thereto. Moreover, the top side 211 of the at least one chip 21 exposed from the encapsulant 31 is covered by the recognition contrast layer 32, thereby effectively preventing the at least one chip 21 from being exposed in an external environment through an adjacent one of the slots 313.

### [Fourth Embodiment]

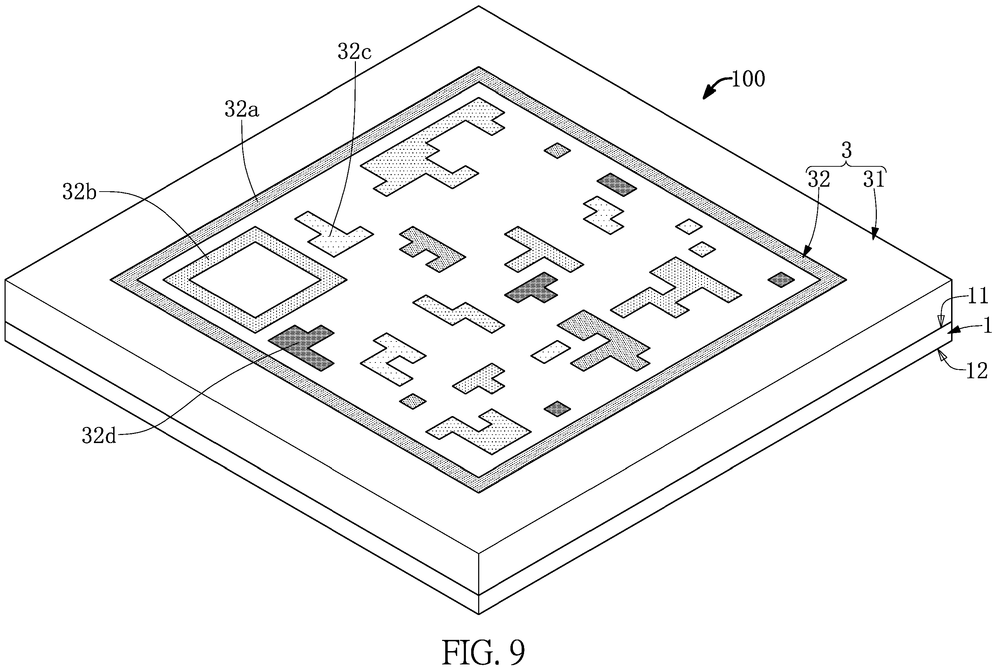

Referring to FIG. 9, a fourth embodiment of the present disclosure, which is similar to the first to third embodiments of the present disclosure, is provided. For the sake of brevity, descriptions of the same components in the first to fourth embodiments of the present disclosure will be omitted herein, and the following description only discloses different features among the first to fourth embodiments.

In the present embodiment, the encapsulant 31 is of a single color (e.g., the color of the encapsulant 31 is black), and the recognition contrast layer 32 has a plurality of regions 32a, 32b, 32c, 32d respectively having different colors according to design requirements (e.g., the regions 32a, 32b, 32c, 32d can be toner layers having different colors). Any one of the different colors of the recognition contrast layer 32 and the color of the encapsulant 31 are provided by conforming to grade A or grade B in the ISO/IEC 15415 standard, thereby allowing the predetermined 2D code pattern to have different appearances.

### [Beneficial Effects of the Embodiments]

In conclusion, any one of the chip package structure and the package module of the present disclosure is provided with the predetermined 2D code pattern that is formed by a structural cooperation of the encapsulant and the recognition contrast layer, so that the predetermined 2D code pattern not only provides for high recognition accuracy, but also has a planar shape that is not easily damaged.

Specifically, in the chip package structure provided by the present disclosure, the recognition contrast layer covers inner walls of the slots, thereby effectively preventing the at least one chip from being affected by the external environment.

Moreover, in the chip package structure provided by the present disclosure, the recognition contrast layer can include different colors according to design requirements, thereby allowing the predetermined 2D code pattern to have different appearances.

The foregoing description of the exemplary embodiments of the disclosure has been presented only for the purposes of illustration and description and is not intended to be exhaustive or to limit the disclosure to the precise forms disclosed. Many modifications and variations are possible in light of the above teaching.

The embodiments were chosen and described in order to explain the principles of the disclosure and their practical application so as to enable others skilled in the art to utilize the disclosure and various embodiments and with various modifications as are suited to the particular use contemplated. Alternative embodiments will become apparent to those skilled in the art to which the present disclosure pertains without departing from the appended claims.

## Claims

1. A chip package structure (100), comprising:
a substrate (1) having a first board surface (11) and a second board surface (12) that is opposite to the first board surface (11), wherein the substrate (1) has a plurality of conductive portions (13) arranged on the second board surface (12);
a chip module (2) mounted on the first board surface (11) and electrically coupled to the conductive portions (13);
an encapsulant (31) formed on the first board surface (11), wherein the chip module (2) is embedded in the encapsulant (31), and wherein the encapsulant (31) has a patterned trench (312) that is recessed in a top surface (311) thereof and that corresponds in shape to a predetermined two-dimensional (2D) code pattern; and
a recognition contrast layer (32) filled in the patterned trench (312), the chip package structure is **characterized in that**
the recognition contrast layer (32) and the top surface (311) of the encapsulant (31) respectively have different colors that conform to grade A or grade B in ISO/IEC 15415 standard;
wherein the recognition contrast layer (32) is coplanar with the top surface (311) of the encapsulant (31) so as to jointly form the predetermined 2D code pattern having a planar shape;
wherein the patterned trench (312) has a plurality of slots (313) that are separate from each other, and each of the slots has a depth (D313) within a range from 15 µm to 30 µm;
wherein the chip module (2) includes at least one chip (21) and a plurality of passive components (22), and wherein the at least one chip (21) and the passive components (22) are mounted on the first board surface (11), and a top side (211) of the at least one chip (21) is exposed from at least one of the slots (313) and is covered by the recognition contrast layer (32).

2. The chip package structure (100) according to claim1, wherein each of the slots is a laser engraving slot, and the recognition contrast layer (32) is a toner layer.

3. The chip package structure (100) according to claim 1, wherein the top side (211) of the at least one chip (21) is embedded in the encapsulant (31) and is spaced apart from at least one of the slots (313) adjacent thereto by a distance (D211) within a range from 1 µm to 10 µm.

4. The chip package structure (100) according to claim 1, wherein the encapsulant (31) is of a single color, and the recognition contrast layer (32) has a plurality of regions (32a, 32b, 32c, 32d) respectively having different colors.

5. The chip package structure (100) according to claim 1, further comprising a transparent protective layer (33) covering the predetermined 2D code pattern having the planar shape.

## Patentansprüche

1. Chip-Package-Aufbau (100), aufweisend:
ein Substrat (1), welches eine erste Plattenfläche (11) und eine zweite Plattenfläche (12) hat, welche entgegengesetzt zu der ersten Plattenfläche (11) ist, wobei das Substrat (1) mehrere leitfähige Abschnitte (13) hat, welche an der zweiten Plattenfläche (12) angeordnet sind;
ein Chip-Modul (2), welches an der ersten Plattenfläche (11) montiert ist und mit den leitfähigen Abschnitten (13) elektrisch verbunden ist;
ein Einkapselungsmaterial (31), welches an der ersten Plattenfläche (11) gebildet ist, wobei das Chip-Modul (2) in dem Einkapselungsmaterial (31) eingebettet ist, und wobei das Einkapselungsmaterial (31) einen gemusterten Graben (312) hat, welcher in einer oberen Seite (311) davon eingelassen ist und hinsichtlich einer Form mit einem vorbestimmten zweidimensionalen (2D) Codemuster korrespondiert; und
eine Erkennungskontrastschicht (32), welche in den gemusterten Graben (312) eingefüllt ist;
wobei der Chip-Package-Aufbau **dadurch gekennzeichnet ist, dass**:
die Erkennungskontrastschicht (32) und die obere Fläche (311) des Einkapselungsmaterials (31) jeweils verschiedene Farben haben, welche der Gütestufe A oder der Gütestufe B der ISO/IEC 15415 Norm entsprechen;
wobei die Erkennungskontrastschicht (32) komplanar mit der oberen Fläche (311) des Einkapselungsmaterials (31) ist, um gemeinsam das vorbestimmte 2D-Codemuster zu bilden, welches eine ebene Form hat;
wobei der gemusterte Graben (312) mehrere Schlitze (313) hat, welche voneinander getrennt sind, und jeder von den Schlitzen eine Tiefe (D313) innerhalb von einem Wertebereich von 15 µm bis 30 µm hat;
wobei das Chip-Modul (2) mindestens einen Chip (21) und mehrere passive Komponenten (22) aufweist, und wobei der mindestens eine Chip (21) und die passiven Komponenten (22) an der ersten Plattenfläche (11) montiert sind, und wobei eine obere Seite (211) von dem mindestens einen Chip (21) von mindestens einem von den Schlitzen (313) aus freigelegt ist und mittels der Erkennungskontrastschicht (32) bedeckt ist.

2. Chip-Package-Aufbau (100) gemäß Anspruch 1, wobei jeder von den Schlitzen ein Lasergravur-Schlitz ist, und die Erkennungskontrastschicht (32) eine Tonerschicht ist.

3. Chip-Package-Aufbau (100) gemäß Anspruch 1, wobei die obere Seite (211) von dem mindestens einen Chip (21) in dem Einkapselungsmaterial (31) eingebettet ist und von mindestens einem von den Schlitzen (313), welche benachbart dazu sind, um einen Abstand (D211) innerhalb von einem Wertebereich von 1 µm bis 10 µm beabstandet ist.

4. Chip-Package-Aufbau (100) gemäß Anspruch 1, wobei das Einkapselungsmaterial (31) einfarbig ist, und die Erkennungskontrastschicht (32) mehrere Regionen (32a, 32b, 32c, 32d) hat, welche in jeweils zugeordneter Weise verschiedene Farben haben.

5. Chip-Package-Aufbau (100) gemäß Anspruch 1, welcher ferner eine transparente Schutzschicht (33) aufweist, welche das vorbestimmte 2D-Codemuster bedeckt, welches die ebene Form hat.

## Revendications

1. Structure de boîtier de puce (100), comprenant :
un substrat (1) ayant une première surface de carte (11) et une deuxième surface de carte (12) qui est opposée à la première surface de carte (11), le substrat (1) ayant une pluralité de parties conductrices (13) disposées sur la deuxième surface de carte (12) ;
un module de puce (2) monté sur la première surface de carte (11) et couplé électriquement aux parties conductrices (13) ;
un encapsulant (31) formé sur la première surface de carte (11), le module de puce (2) étant noyé dans l'encapsulant (31), et l'encapsulant (31) ayant une tranchée à motifs (312) qui est évidée dans sa surface supérieure (311) et dont la forme correspond à un motif de code bidimensionnel (2D) prédéterminé ; et
une couche de contraste de reconnaissance (32) remplie dans la tranchée à motifs (312), la structure de boîtier de puce étant **caractérisée en ce que** :
la couche de contraste de reconnaissance (32) et la surface supérieure (311) de l'encapsulant (31) ont respectivement des couleurs différentes conformes au grade A ou au grade B de la norme ISO/IEC 15415 ;
dans laquelle la couche de contraste de reconnaissance (32) est coplanaire avec la surface supérieure (311) de l'encapsulant (31) de manière à former conjointement le motif de code 2D prédéterminé ayant une forme plane ;
dans laquelle la tranchée à motifs (312) comporte une pluralité de fentes (313) séparées les unes des autres, et chacune des fentes a une profondeur (D313) comprise dans une plage allant de 15 µm à 30 µm ;
dans laquelle le module de puce (2) comprend au moins une puce (21) et une pluralité de composants passifs (22), et dans laquelle ladite au moins une puce (21) et les composants passifs (22) sont montés sur la première surface de carte (11), et une face supérieure (211) de ladite au moins une puce (21) est exposée à partir d'au moins une parmi les fentes (313) et est recouverte par la couche de contraste de reconnaissance (32).

2. Structure de boîtier de puce (100) selon la revendication 1, dans laquelle chacune des fentes est une fente de gravure au laser, et la couche de contraste de reconnaissance (32) est une couche de toner.

3. Structure de boîtier de puce (100) selon la revendication 1, dans laquelle la face supérieure (211) de ladite au moins une puce (21) est noyée dans l'encapsulant (31) et est espacée d'au moins une des fentes (313) qui lui sont adjacentes d'une distance (D211) comprise dans une plage allant de 1 µm à 10 µm.

4. Structure de boîtier de puce (100) selon la revendication 1, dans laquelle l'encapsulant (31) est d'une seule couleur, et la couche de contraste de reconnaissance (32) présente une pluralité de régions (32a, 32b, 32c, 32d) ayant respectivement des couleurs différentes.

5. Structure de boîtier de puce (100) selon la revendication 1, comprenant en outre une couche de protection transparente (33) couvrant le motif de code 2D prédéterminé ayant la forme plane.
